(19) Europäisches Patentamt

European Patent Office

Office européen des brevets

(11) **EP 0 825 533 A1**

(12) **EUROPEAN PATENT APPLICATION**

(43) Date of publication:
25.02.1998 Bulletin 1998/09

(51) Int. Cl.⁶: $G06F\ 11/00$, $H03M\ 13/00$

(21) Application number: 97114081.9

(22) Date of filing: 14.08.1997

(84) Designated Contracting States:
AT BE CH DE DK ES FI FR GB GR IE IT LI LU MC NL PT SE

(30) Priority: 15.08.1996 JP 215629/96

(71) Applicant: NEC CORPORATION
Tokyo (JP)

(72) Inventor:
Yoshimura, Miho,
c/o NEC Corporation
Tokyo (JP)

(74) Representative:
Baronetzky, Klaus, Dipl.-Ing. et al
Patentanwälte
Dipl.-Ing. R. Splanemann, Dr. B. Reitzner, Dipl.-Ing. K. Baronetzky
Tal 13
80331 München (DE)

(54) **Method and circuit for calculating and processing error correction**

(57) The multiplications to find an error locator polynomial and an error evaluator polynomial are processed in parallel using a multiplier and an adder for each polynomial, the judgement whether the coefficient of the polynomial necessary for finding a degree of the polynomial from this calculated result is zero or not is effected one by one with a zero check circuit right after the calculation, and the processes for the calculation and the degree are effected in parallel, thereby enabling the miniaturization of the circuit as well as the high speed processing.

*FIG. 4*

7~10 $\boxed{\times}$ ; Multiplier on the Galois Field

11,12 $\oplus$ ; Adder on the Galois Field

EP 0 825 533 A1

## Description

The present invention relates to a method and circuit for calculating and processing error correction, and more particularly, to the method and circuit for calculating and processing error correction to realize the Euclid's algorithm.

One of the conventional circuits for calculating and processing error correction is disclosed, for example, in Japanese Laid Open Patent Publication No. 276825/89. This circuits for calculating and processing has an advantages which can considerably reduce the time to process error correction as described in detail hereinafter.

However, in such a conventional circuit for calculating and processing, a number of circuits for calculating are used and the calculations are simultaneously performed, resulting in a large scaled circuits.

Accordingly, it is an object of the present invention to provide a method for calculating and processing which can be miniaturized and the same time the calculation and processing can be effected at high speed.

According to the first feature of the present invention, a method for calculating and processing the error correction, comprises the step of: executing three processes consisting of syndrome calculation, execution of the Euclid's algorithm and chien search, and error correction in parallel in the error correction by the Reed-Solomon code.

According to the second feature of the present invention, a circuit for calculating and processing the error correction, comprising a computer in which the calculation of two polynomials taking the element on the Galois field as a coefficient is executed for each of the polynomials in a circuit for calculating and processing to find an error locator polynomial and an error evaluator polynomial by the Euclid's algorithm.

The invention will be explained in more detail in conjunction with appended drawings, wherein:

Fig. 1 is a block diagram showing the entire construction of an error correction system in the prior art;
Fig. 2 is a flow chart showing the operation of Euclid's algorithm in the prior art;
Fig. 3 is a circuit diagram showing one example of the prior techniques;
Fig. 4 is a circuit diagram showing a calculating and processing circuit in a first preferred embodiment according to the present invention;
Fig. 5 is a timing diagram showing the operation of the first preferred embodiment shown in Fig. 4;
Fig. 6 is a schematic diagram of the pipeline processing to form a basic for the present invention; and
Fig. 7 is a circuit diagram showing a calculating and processing circuit in a second preferred embodiment according to the present invention.

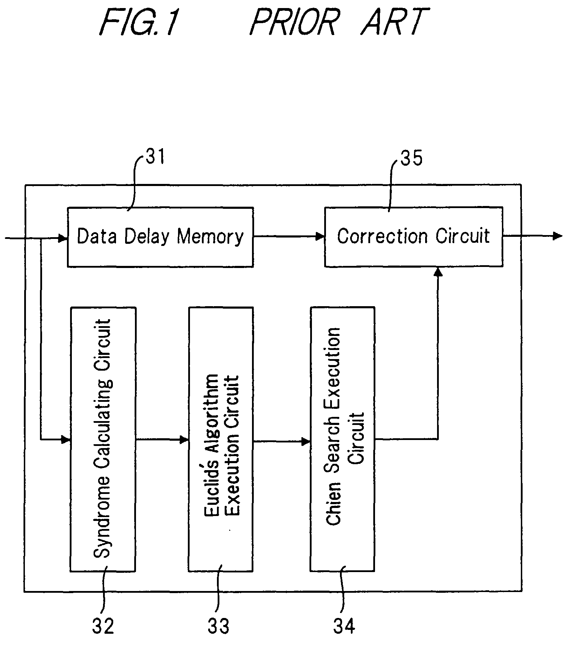

Before explaining the method and circuit for calculating and processing error correction in the preferred embodiments according to the present invention, the background of the invention will be explained in conjunction with Figs. 1 to 3.

In order to perform the error correction using the Reed-Solomon code, it is generally required the following four processes:

(1) syndrome is calculated from received data;
(2) an error locator polynomial and an error evaluator polynomial are found from the syndrome;
(3) error locator are found from the error locator polynomial; and
(4) an error numerical values are found from the error locator polynomial, the error evaluator polynomial and the error locator, and the resulting error values are corrected.

In the error correction using the Reed-Solomon code having a large correctability, as one of the methods (2) for finding the error locator polynomial and the error evaluator polynomial described above, is well known the Euclid's algorithm utilizing the mutual division to find the greatest common measure or factor for the two polynomials.

Fig. 1 shows the entire construction of such a conventional error correction system. This system comprises a data delay memory 31 storing the data between the input and correction of received data because of decoding delay accompanied therebetween, a syndrome calculating circuit for calculating the syndrome from the received data, an Euclid's algorithm execution circuit 33 to find an error locator polynomial and an error evaluator polynomial from the syndrome, chien search execution circuit 34 to find error locators and error values from the error locator polynomial and the error evaluator polynomial and a correction circuit 35 to execute the correction based on the error locator and the error values.

Then, the Euclid's algorithm for finding an error locator polynomial and an error evaluator polynomial from the syndrome as an example of the t-error-correction by the Reed-Solomon code on the Galois field GF (2n) will be described. First, from the syndrome s0-s2t-1 found from the received data, a syndrome polynomial may be taken as the following:

$$S(X) = s_0 + s_i X + \cdots + s_{2t-1} x^{2t-1} \qquad (1)$$

Also, an error locator polynomial may be taken as the followiing:

$$\sigma(x) = (1 - \alpha^{jl} x) \cdot \cdots \cdot (1 - \alpha^{jk} x) \qquad (2)$$

wherein

$\alpha$ is the root of primitive polynomial; and

jl ··· jk: the error locator.

The relation between the syndrome polynomial S(X) and the error locator polynomial $\sigma(x)$ is represented by the following formulas (3) and (4):

$$\phi(x)x^{2t} + \alpha(x)S(x) = \omega(x) \qquad (3)$$

$$\deg\omega(x) < \deg\sigma(x) \leqq t-1 \qquad (4)$$

wherein

$\omega(x)$: error evaluator polynomial;

$\phi(x)$: arbitrary polynomial on $GF(2^n)$;

n: degree of primitive polynomial;

t: correctable error number;

$\deg\omega(x)$: degree of error evaluator polynomial $\omega(x)$; and

$\deg\sigma(x)$: degree of error locator polynomial $\sigma(x)$.

The error locator polynomial $\sigma(x)$ and the error evaluator polynomial $\omega(x)$ to satisfy the formulas (3) and (4) can be found in the process of the Euclidean mutual division for finding the greatest common measure of the $x^{2t}$ and the syndrome polynomial S(x). Letting

$$R_{-1}(x)=x^{2t}, R_0(x)=S(x) \qquad (5),$$

the polynomials $A_i(x)$, $B_i(x)$ and $R_i(x)$ to satisfy the formula (6) are found one by one:

$$A_i(x)R_{-1}(x) + B_i(x)R_0(x) = R_i(x) \qquad (6).$$

When the degree of $B_i(x)$ is less than t, and the degree of $R_i(x)$ is less than t-1, $B_i(x)$ and $R_i(x)$ can become the error locator polynomial $\sigma(x)$ and the error evaluator polynomial $\omega(x)$, respectively.

The method for effectively finding the polynomials $A_i(x)$, $B_i(x)$ and $R_i(x)$ is to execute the following calculations:

$$Q_i(x) = [R_{i-2}(x)/R_{i-1}(x)] \qquad (7)$$

$$R_i(x) = R_{i-2}(x) - Q_i(x)R_{i-1}(x) \qquad (8)$$

$$A_i(x) = A_{i-2}(x) - Q_i(x)A_{i-1}(x) \qquad (9)$$

$$B_i(x) = B_{i-2}(x) - Q_i(x)B_{i-1}(x) \qquad (10)$$

wherein

[ ] : quotient polynomial

i: [1, 2, 3, ···, ]

$A_{-1}(x) = 1$

$A_0(x) = 0$

$B_{-1}(x) = 0$

$B_0(x) = 1$

The operation to execute the calculation of this formula (8) is the Euclidean mutual division operation itself.

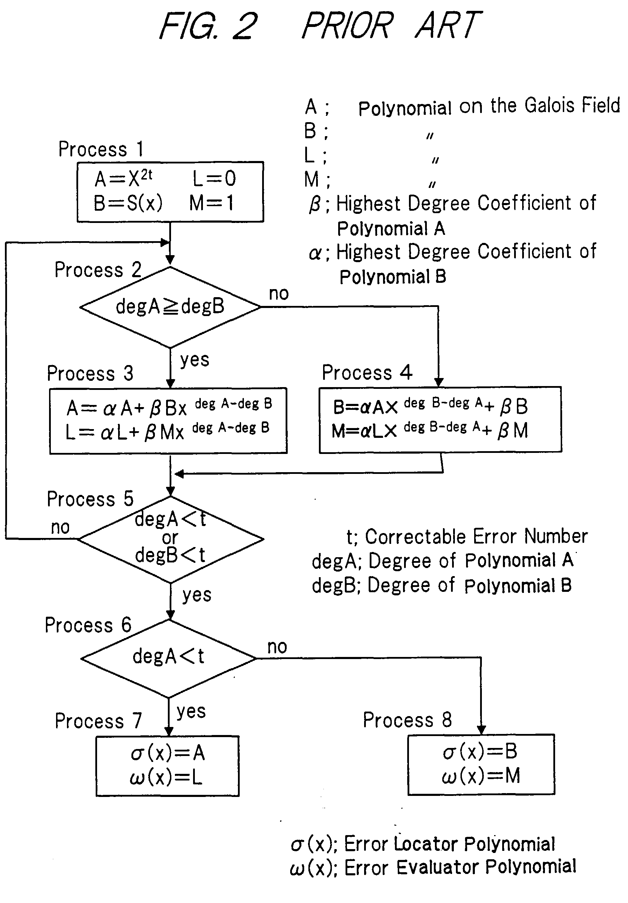

Fig. 2 is a flow chart showing the operation of the Euclid's algorithm. In Fig. 2, $\alpha$ and $\beta$ represent the highest degree coefficient of polynomials B and A, respectively and by alternately multiplying them by the polynomials A and B, the originally necessary division (the division corresponding to the formula (7)) is omitted. Evidently from this Fig. 2, the execution of the Euclid's algorithm upon error correction using the Reed-Solomon code requires the calculation of the polynomial taking the element on the Galois field as a coefficient, and finding the degree of the polynomial.

In this way, the calculation of the polynomial taking the element on the Galois field as a coefficient has been executed using an exclusive Galois calculation unit. This is executed by using a single Galois calculation unit, and it requires the calculations of (2x2tx2t) times. Therefore, the conventional circuit for calculating and processing takes a longer time and is not suitable for a high speed processing.

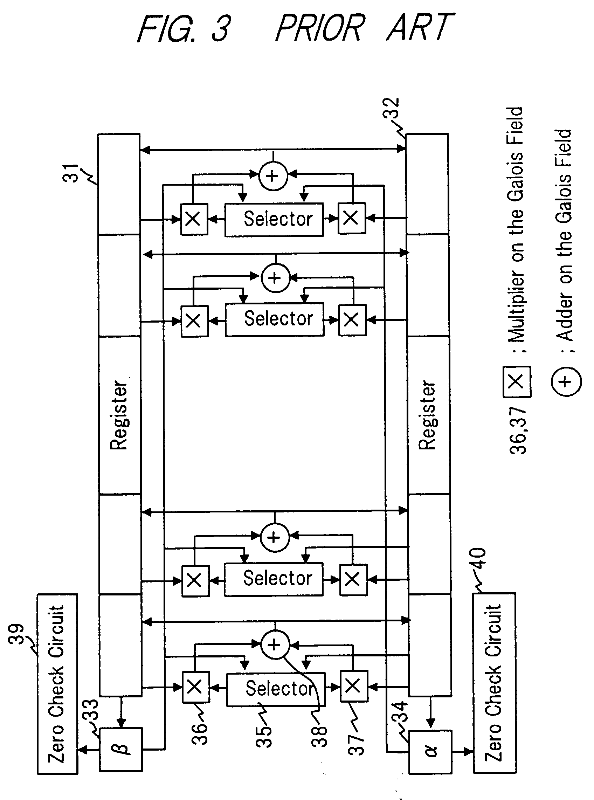

On the other hand, Japanese Laid-Open Patent Publication No. 276825/89 discloses a circuit for calculating and processing of which object is to find the error locator polynomial and error evaluator polynomial at a high speed using the Euclidean mutual division. Fig. 3 shows one example of the circuits shown in this patent. This circuit has a register 31 for storing the coefficients of polynomials A and M, a register 32 for storing the coefficients of polynomials B and L, a register 33 for storing the highest degree coefficient $\beta$ of the polynomial A, a register 34 for storing the highest degree coefficient $\alpha$ of the polynomial B, zero check circuits 39 and 40, a selector 35 to select the $\alpha$ and $\beta$, plural multipliers 36, 37 on the Galois field and plural adders 38 on the Galois field. In this construction, there are provided (2t+1) multipliers 36 on the Galois field for each coefficient of the polynomials A and M, and (2t+1) multipliers 37 on the Galois field for each coefficient of the polynomials B and L, that is, two polynomial calculations by the Euclidian mutual division are processed in parallel with (2x(2t+1)) multipliers. Accordingly, the processes can be ended with conversions of (2t) times, thereby enabling the processing time to reduce. However, in the construction for simultaneously calculating using such a large number of calculating circuits, the multipliers on the Galois field require about 500 gates per multiplier, resulting a large scale in the number of times.

Next, a circuit for calculating and processing error correction in the first preferred embodiment according to the present invention will be described.

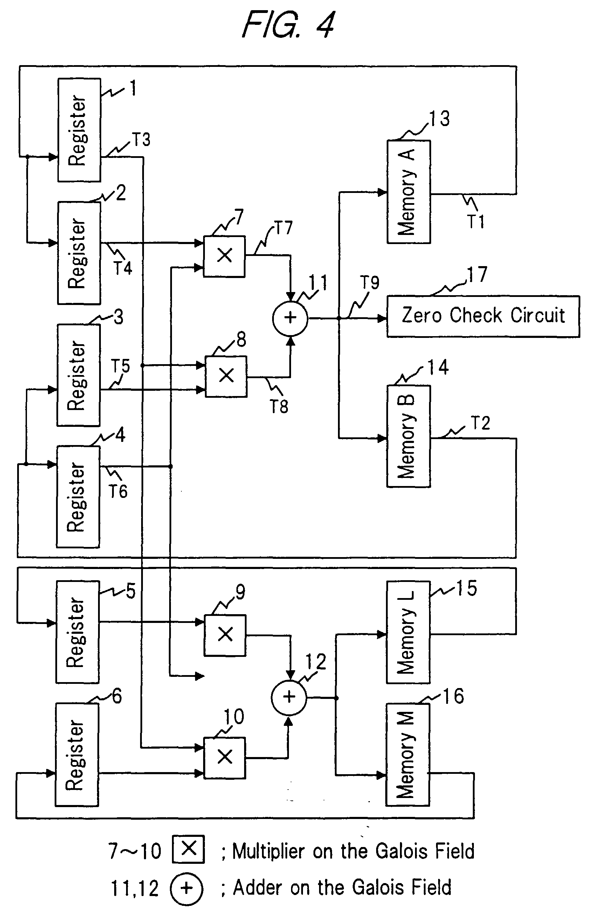

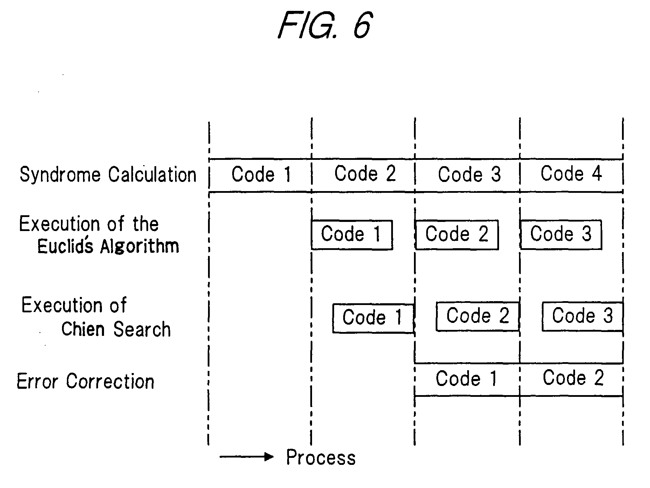

Fig. 4 shows a circuit for calculating and processing error correction in the first preferred embodiment according to the present invention. As shown in Fig. 6, this preferred embodiment is based on the fact that in the error correction with the Reed-Solomon code, the decoding delay time can be reduced by the error correction with pipeline processing. That is, a high speed processing can be executed by three processings consisting of syndrome calculation, execution of the Euclid's algorithm and chaining search, and error correction. In addition, the syndrome is calculated by the step in the code length of the Reed-Solomon code, so that the processing of the Euclid's algorithm and chaining search in the time equal to the time taking for the syndrome processing is sufficient.

Then, in the the Euclid's algorithm, the degrees of the polynomials are found by executing the calculations for two polynomials with an adder for each polynomial, and one by one judging whether the the result is zero or not. That is, the degree of the polynomial A or B is found by judging one by one whether the degree of the polynomial $\alpha A + \beta Bx^{degA\ -degB}$, or $\alpha Ax^{degB-degA} + \beta B$ is zero or not which is the calculated result of said polynomial A or B, respectively, thereby attempting the high speed processing. In addition, the miniaturization of the circuit size can be effected by multiplying the highest degree coefficients $\alpha$, $\beta$ by each coefficient in polynomials A, B, L and M with an adder for each polynomial.

The circuit for calculating and processing shown in Fig.4 comprises six registers 1 to 6, four multipliers 7 to 10 on the Galois field, two adders 11 and 12 on the Galois field, four memories 13 to 16, and a zero check circuit 17. The A memory 13, B memory 14, L memory 15, and M memory 16 have each coefficient $a_i$ of the polynomial A, each coefficient $b_i$ of the polynomial B, each coefficient $l_i$ of the polynomial L, and each coefficient $m_i$ of the polynomial M stored, respectively, so that the sizes of the A memory 13, B memory 14, L memory 15, and M memory 16 are (2t+1) words, (2t) words, (t+1) words and (t+1) words, respectively.

Next, operation of the circuit shown in Fig. 4 will be described. First, an initial value is written onto each of the memories in the initial state. That is, the coefficient of $x^{2t}$, the coefficient of syndrome polynomial $S(x)= s_0 + s_ix + \cdots + s_{2t-1}x^{2t-1}$, 0, and 1 are written onto the A memory 13, B memory 14, L memory 15, and M memory 16, respectively (corres. to the processing 1 shown in Fig. 1).

Then, as an example of operation of the Euclid's algorithm, the operation to find $\alpha A + \beta Bx^{degA-degB}$ from the polynomials A and B, and $\alpha L + \beta Mx^{degA-degB}$ from the polynomials L and M (corres. to the operation of the processings $2 \rightarrow 3 \rightarrow 5$) is described below. Respective coefficients read out of the memories 13 to 16 are latched to the registers 1 to 6, respectively. The highest

degree coefficient $\beta$ of the polynomial A, coefficient $a_i$ of the polynomial A, coefficient $b_i$ of the polynomial B, the highest degree coefficient $\alpha$ of the polynomial B, coefficient $l_i$ of the polynomial L, and coefficient $m_i$ of the polynomial M are latched to the registers 1, 2, 3, 4, 5 and 6 in from higher to lower orders, respectively.

The resulting coefficient $\alpha a_i + \beta b_i$ of the polynomial $\alpha A + \beta Bx^{degA\ -degB}$ and coefficient $\alpha l_i + \beta m_i$ of the polynomial $\alpha L + \beta Mx^{degA\ -degB}$ can be found in from higher to lower degree orders by the multipliers 7 and 8 and the adder 11, and the multipliers 9 and 10 and the adder 12, respectively. These calculated results are written into the A memories 13 and 15, respectively. Further, simultaneously with the writing into the memories, it is judged whether the coefficient $\alpha a_i + \beta b_i$ of the polynomial $\alpha A + \beta Bx^{degA\ -degB}$ is zero or not by the zero check circuit 17, and if it is not zero, the degree of the the polynomial $\alpha A + \beta Bx^{degA\ -degB}$ can be found.

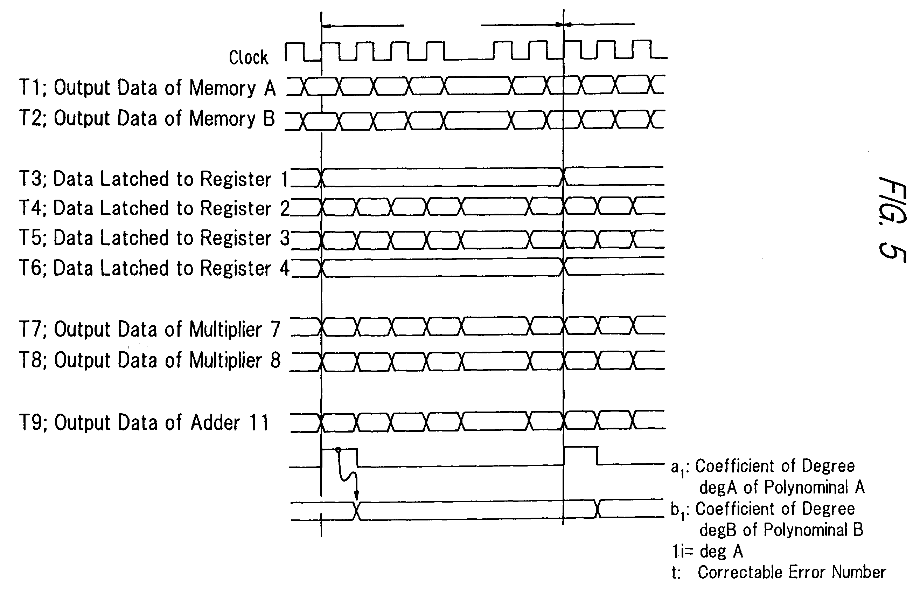

Fig. 5 is a timing diagram showing the operation of the Euclid's algorithm calculating and processing (refer to the operations $2 \rightarrow 3 \rightarrow 5$ shown in Fig. 2) in respect to the polynomials A and B, and the operations of zero check and determining the degree of the polynomial A. The data (T1 and T2) read out of the A memory 13 and B memory 14 are latched to the registers 1 to 4 (T3, T4, T5, T6), respectively, and calculated by the multipliers 7, 8 and the adder 11. T9 is the calculated result, that is, the coefficient $\alpha a_i + \beta b_i$ of the polynomial $\alpha A + \beta Bx^{degA\ -degB}$, and it is judged whether this coefficient is zero or not in the zero check circuit 17 to find the degree of the polynomial. In this way, the processing involving the Euclid's algorithm can be finished with the steps of at highest (2tx2t) by effecting the processing of calculation and degree of the polynomial in parallel.

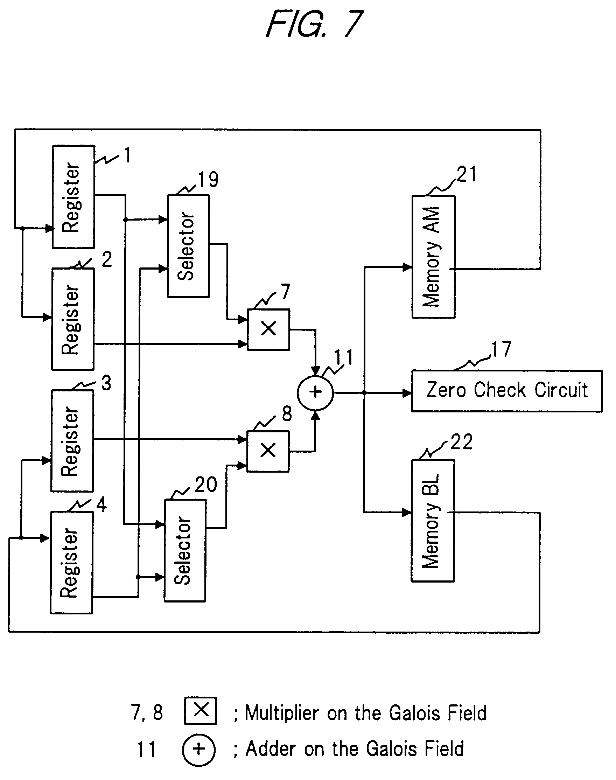

Fig. 7 shows a circuit for calculating and processing error correction in the second preferred embodiment according to the present invention. In this embodiment, the sum in degrees of the polynomials A and M is always equal, and also, the sum in degrees of the polynomials B and L is always equal, so that the the polynomials A and M, and the polynomials B and L can be stored into the memory having a size of (2t+1) words, respectively. Accordingly, this circuit comprises four registers 1 to 4, two multipliers 7 and 8 on the Galois field, one adder 11 on the Galois field, two memories 21 and 22, a zero check circuit 17 and two selectors 19 and 20 for selecting the highest degree in the polynomials A, and B, and thus this circuit in the second preferred embodiment can be more miniaturized than that of the first preferred embodiment. In this connection, the processing accompanied by the Euclid's algorithm by steps of (2tx(2t+1)) in this preferred embodiment.

As described above, the calculations to find the error locator polynomial and the error evaluator polynomial are processed in parallel using an adder for each polynomial in the present invention and thus, fewer multipliers can be used and the calculating and processing circuit accompanied by the Euclid's algorithm can be miniaturized. In addition, the judgement whether the coefficient of polynomial necessary to find the degree of the polynomial is zero or not is effected right after calculation of the polynomial, so that the processing of the calculation and the processing of the degree can be effected in parallel and the processings for the calculation and degree can be executed at high speed.

The preferred embodiments of the present invention have been disclosed by way of example and it will be understood that other modifications may occur to those skilled in the art without departing from the scope and the spirit of the appended claims.

**Claims**

1. A method for calculating and processing the error correction, comprising the step of: executing three processes consisting of syndrome calculation, execution of the Euclid's algorithm and chein search, and error correction in parallel in the error correction by the Reed-Solomon code.

2. A method for calculating and processing the error correction, comprising the step of: executing the calculations of two polynomials taking the element on the Galois field as a coefficient simultaneously in calculating and processing to find an error locator polynomial and an error evaluator polynomial by the Euclid's algorithm.

3. A method for calculating and processing the error correction, comprising the step of: executing the calculation and process of the polynomial taking the element on the Galois field as a coefficient, and the process to find a degree of the polynomial by one by one judging whether the degree of the polynomial is zero or not from the result of said calculation result in parallel in calculating and processing to find the error locator polynomial and the error evaluator polynomial by the Euclid's algorithm.

4. A circuit for calculating and processing the error correction, comprising: a computer in which the calculation of two polynomials taking the element on Galois field as a coefficient is executed for each of said polynomials in a circuit for calculating and processing to find an error locator polynomial and an error evaluator polynomial by the Euclid's algorithm.

5. A circuit for calculating and processing the error correction as defined in claim 4, further comprises a plurality of memories to store a coefficient of respective polynomials; a plurality of registers to latch a coefficient read out of each of said memories; a plurality of multipliers and adders for calculating said coefficient latched to said respective registers for each said polynomial; and a zero check circuit to judge whether the coefficient of said polynomial obtained by said calculation is zero or not.

6. A circuit for calculating and processing the error correction as defined in claim 5, further comprises: a selector to select the required degree coefficient among said coefficients latched in said registers.

## FIG.1    PRIOR ART

Data Delay Memory — 31

Correction Circuit — 35

Syndrome Calculating Circuit — 32

Euclid's Algorithm Execution Circuit — 33

Chien Search Execution Circuit — 34

# FIG. 2 PRIOR ART

A ;   Polynomial on the Galois Field
B ;           //
L ;           //
M ;          //
$\beta$ ; Highest Degree Coefficient of Polynomial A
$\alpha$ ; Highest Degree Coefficient of Polynomial B

**Process 1**

$$A = X^{2t} \quad L = 0$$
$$B = S(x) \quad M = 1$$

**Process 2**

$degA \geqq degB$ — no / yes

**Process 3**

$$A = \alpha A + \beta B x^{\,deg\ A - deg\ B}$$
$$L = \alpha L + \beta M x^{\,deg\ A - deg\ B}$$

**Process 4**

$$B = \alpha A X^{\,deg\ B - deg\ A} + \beta B$$
$$M = \alpha L X^{\,deg\ B - deg\ A} + \beta M$$

**Process 5**

$degA < t$ or $degB < t$ — no / yes

t; Correctable Error Number
degA; Degree of Polynomial A
degB; Degree of Polynomial B

**Process 6**

$degA < t$ — no / yes

**Process 7**

$$\sigma(x) = A$$
$$\omega(x) = L$$

**Process 8**

$$\sigma(x) = B$$
$$\omega(x) = M$$

$\sigma(x)$; Error Locator Polynomial
$\omega(x)$; Error Evaluator Polynomial

# FIG. 3   PRIOR ART

Register

Selector

Register

Selector

Selector

Selector

Zero Check Circuit

Zero Check Circuit

β

α

31

32

33

34

35

36

37

38

39

40

36,37 ☒ : Multiplier on the Galois Field

⊕ : Adder on the Galois Field

EP 0 825 533 A1

# FIG. 4

7~10 ⊠ ; Multiplier on the Galois Field

11,12 ⊕ ; Adder on the Galois Field

9

Clock

T1; Output Data of Memory A

T2; Output Data of Memory B

T3; Data Latched to Register 1

T4; Data Latched to Register 2

T5; Data Latched to Register 3

T6; Data Latched to Register 4

T7; Output Data of Multiplier 7

T8; Output Data of Multiplier 8

T9; Output Data of Adder 11

$a_i$: Coefficient of Degree degA of Polynominal A

$b_i$: Coefficient of Degree degB of Polynominal B

$1i=$ deg A

t: Correctable Error Number

FIG. 5

EP 0 825 533 A1

# FIG. 6

*FIG. 7*

7, 8 ☒ ; Multiplier on the Galois Field

11 ⊕ ; Adder on the Galois Field

European Patent
Office

**EUROPEAN SEARCH REPORT**

Application Number

EP 97 11 4081

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | EP 0 545 498 A (BTS)<br>* page 5, line 51 – page 8, line 56; figures * <br>--- | 1-4 | G06F11/00<br>H03M13/00 |
| A | US 5 170 399 A (CAMERON ET AL.)<br>* column 3, line 39 – column 8, line 54; figures *<br>--- | 1-4 | |
| A | US 4 868 828 A (SHAO ET AL.)<br>* column 12, line 14 – column 17, line 14; figures *<br>--- | 1-4 | |
| A | EP 0 458 285 A (TOSHIBA)<br>* page 5, line 14 – page 10, line 55; figures *<br>--- | 2-4 | |
| A | EP 0 329 789 A (MATSUSHITA)<br>* page 4, line 3 – page 8, column 58, line – *<br>--- | 2-4 | |
| A | US 5 099 482 A (CAMERON)<br>* column 3, line 33 – column 8, line 24; figures *<br>----- | 2-4 | TECHNICAL FIELDS SEARCHED (Int.Cl.6)<br><br>H03M |

The present search report has been drawn up for all claims

| Place of search | Date of completion of the search | Examiner |
|---|---|---|
| THE HAGUE | 24 November 1997 | Geoghegan, C |

CATEGORY OF CITED DOCUMENTS

X : particularly relevant if taken alone
Y : particularly relevant if combined with another
   document of the same category
A : technological background
O : non–written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)